# EUROPÄISCHE PATENTSCHRIFT

(11) **EP 1 944 110 B1**
(45) Veröffentlichungstag und Bekanntmachung des Hinweises auf die Patenterteilung: **07.11.2012**
(21) Anmeldenummer: 07100536.7
(22) Anmeldetag: 15.01.2007
(51) Int. Cl.: B23C 5/10, B23P 15/34, C23C 30/00

(54) **Verfahren zur Behandlung und Bearbeitung von Werkzeugen zur spanabhebenden Bearbeitung von Werkstücken**
Method of processing and machining tools for the machining of workpieces by chip removal
Procédé destiné à la manipulation et au traitement d'outils destinés au traitement par enlèvement de copeaux de pièces usinées

(43) Veröffentlichungstag der Anmeldung: 16.07.2008
(73) Patentinhaber: Fraisa Holding AG, 4512 Bellach (CH)
(72) Erfinder: Maushart, Josef, 4500, Solothurn (CH); Sichi, Tiziano, 4542, Luterbach (CH); Rechberger, Johann, 3068, Utzigen (CH)
(74) Vertreter: BOVARD AG

(56) Entgegenhaltungen:
- EP-A- 1 306 150
- EP-A1- 0 693 574
- WO-A-2005/014210
- JP-A- 6 190 622
- JP-A- 2000 107 926
- US-A- 4 755 399
- US-A- 5 467 670
- US-A1- 2002 071 949
- US-B1- 6 410 121

## Beschreibung

Die vorliegende Erfindung bezieht sich auf ein Verfahren zur Behandlung und Bearbeitung von Werkzeugen zur spanabhebenden Bearbeitung von Werkstücken, insbesondere Fräswerkzeuge, welche Werkzeuge aus einem hochfesten Stahl, Hartmetall oder Keramik bestehen und mit mindestens einer Schneidflanke und einer Spannut versehen sind, welche Schneidflanke auf der Schneidseite mit einer Schneidkante ausgestattet ist, bei welchem das Werkzeug in einer Beschichtungsanlage mit einer ersten Schicht versehen wird, welche widerstandsfähig ist gegen Freiflächenverschleiss (Abrasionsverschleiss). Ein verfahren gemäß dem Oberbegriff des Anspruchs 1 ist aus der US-Patentschrift Nr. 5 467 670 bekannt

Bei derartigen spanabhebenden Werkzeugen, insbesondere bei Fräswerkzeugen, wird eine hohe Standzeit verlangt, das heisst, dass der Verschleiss der Werkzeuge durch geeignete Massnahmen möglichst klein gehalten werden soll, auch wenn sie für zunehmend schwieriger zu bearbeitende Materialien eingesetzt werden und die Schnittgeschwindigkeiten immer grösser werden, wodurch diese Werkzeuge einer grösseren Belastung ausgesetzt werden.

Es ist bekannt, zur Verbesserung des Verschleissschutzes dieser Werkzeuge und demzufolge zur Erhöhung der Standzeiten diese Werkzeuge mit einer Schicht zu versehen. Diese Schicht besteht beispielsweise aus TiN (Titan-Nitrid). Das Aufbringen einer derartigen Schicht erfolgt in bekannter Weise durch Aufdampfen, beispielsweise durch das PVD (Physical Vapour Deposition)-Verfahren. Dadurch erhält das Werkzeug im Bereich der Schneidflanken und der Spannuten und an der Schneidkante eine widerstandsfähige Schicht mit einer Dicke von einigen Mikrometern. Diese Schicht bietet einen guten Schutz gegen abrasiven Verschleiss.

Es hat sich aber gezeigt, dass bei Werkzeugen, die mit einer derartigen Schicht versehen sind, die Belastungen der Schneidkanten sehr gross sind und dass es trotz einer Beschichtung im Bereich der Schneidkanten zu Ausbrüchen kommen kann. Durch diese Ausbrüche ändert sich die Geometrie der Schneidkante, die Späne können nicht mehr richtig abfliessen, die Zerspanungskräfte steigen massiv an, die Standzeiten werden rasch reduziert.

Aus der US-Patentschrift Nr. 5 467 670 ist ein derartig beschichtetes Werkzeug bekannt. Hierbei werden aber die bei dem Beschichtungsverfahren abgestumpften Schneidkanten wieder geschärft, indem im Bereich der Freifläche ein Anschliff ausgeführt wird. Das so behandelte Werkzeug kann ein zweites Mal beschichtet werden. Die scharfen Schneidkanten sind aber grossen Belastungen ausgesetzt und es kann zu Ausbrüchen kommen.

Die Aufgabe der Erfindung besteht somit darin, ein Verfahren zur Behandlung und Bearbeitung von Werkzeugen, insbesondere Fräswerkzeugen zu schaffen, nach dessen Durchführung ganz allgemein der Verschleiss und insbesondere das Ausbrechen bei den Schneidkanten mindestens eingeschränkt werden kann.

Erfindungsgemäss erfolgt die Lösung dieser Aufgabe bei einem Verfahren gemäß dem Oberbegriff des Anspruchs 1 dadurch, dass danach an den Schneidkanten jeweils eine Fase an der Spanfläche angeschliffen wird, die einen Spanwinkel von -5° bis -30° aufweist und eine Fasenbreite aufweist, die kleiner ist als 5% des Durchmessers des Werkzeugs, und dass auf die angeschliffene Fase in einer Beschichtungsanlage eine zweite Schicht aufgebracht wird, die speziell widerstandsfähig ist gegen Spanflächenverschleiss (Kolkverschleiss).

Ein derartig behandeltes und bearbeitetes Werkzeug erhält eine widerstandsfähige Schichtkombination, die optimiert ist auf abrasiven Verschleiss an der Freifläche und Kolkverschleiss auf der Spanfläche. Durch das Anschleifen der Fase, was in einfacher Weise durch einen Flachschleifvorgang entlang der jeweiligen Schneidkante erfolgt, wird die vorgängig aufgebrachte Schicht im Bereich dieser Fase entfernt. Man erhält dann beschichtete Schneidflanken, beschichtete Schneidkanten, von der Schicht befreite Fasenbereiche und beschichtete Spannuten. Das mit dieser ersten Schicht versehene Werkzeug mit an den Schneidkanten angeschliffenen Fasen wird in einer Beschichtungsanlage mit einer zweiten Schicht versehen, welche widerstandsfähig ist gegen Kolkverschleiss. Derartige Schichten, insbesondere z.B. Al₂O₃, können generell auf komplexen dreidimensionalen Oberflächen und Kanten noch nicht optimal und gut haftend wegen z.B. internen Schichtspannungen abgeschieden werden. Auf der flach geschliffenen Fase treten diese Probleme nicht auf, diese flach geschliffene Fase an den Schneidkanten kann somit in optimaler Weise mit einer derartigen Beschichtung versehen werden.

Durch einen Spanwinkel von -5° bis -30° der Fase wird eine optimal spanabhebende Wirkung erhalten.

Indem die Fase an der jeweiligen Schneidkante des Fräswerkzeugs so angeschliffen wird, dass die Fasenbreite kleiner ist als 5 % des Durchmessers des Werkzeugs, wird die optimale spanabhebende Wirkung unterstützt, insbesondere bei schwierig zu bearbeitenden Materialien und bei hohen Abtragsleistungen. Selbstverständlich ist es auch denkbar, an den Schneidkanten eines Fräswerkzeugs die Fasen derart anzubringen, dass sie unterschiedliche Spanwinkel aufweisen, wodurch das Auftreten von Schwingungen, welche sich durch einen Pfeifton äussern können, wirksam begrenzt werden kann.

Als erste Schicht kann eine Schicht aus CrAIN (Chrom-Aluminium-Nitrid), TiAIN (Titan-Aluminium-Nitrid) oder TiAICN (Titan-Aluminium-Carbo-Nitrid) aufgebracht werden. Derartige Schichten, die mit einer Dicke von etwa 2 bis 3 µm auf das Werkzeug aufgebracht werden, weisen die gewünschte Verschleissfestigkeit auf.

In vorteilhafter Weise wird diese erste Schicht durch Aufdampfen gemäss dem PVD (Physical Vapour Deposition)-Verfahren aufgebracht. Hierdurch erhält man in optimaler Weise eine gleichmässige Beschichtung.

Als erste Schicht zur Beschichtung der Oberfläche des Werkzeugs kann auch eine Diamantschicht verwendet werden. In vorteilhafter Weise wird hierbei die zu beschichtende Oberfläche des Werkzeugs aufgerauht, was bei Hartmetallwerkzeugen durch ein chemisches Anätzen der Kabaltfase erfolgt, wodurch eine mechanische Verankerung der aufgebrachten Diamantschicht an der Oberfläche des Werkzeugs erfolgen kann, wodurch die Diamantschicht in optimaler Weise an der entsprechenden Oberfläche haftet. Eine derartige Diamantschicht ist sehr abrasionsbeständig, aber wegen der Aufrauhung des Substrates nicht sehr glatt. Bei keramischen Substraten ist der Aufrauhvorgang nicht nötig.

In vorteilhafter Weise wird diese Diamantschicht durch Aufdampfen gemäss dem CVD (Chemical-Vapour-Deposition)-Verfahren aufgebracht, was wiederum eine gleichmässige Schichtdicke ermöglicht. Diese Schicht weist eine Dicke von etwa 6 µm auf.

In vorteilhafter Weise wird als zweite Schicht, mit welcher die angeschliffene Fase mit feiner Oberfläche beschichtet wird, eine Schicht aus α-Al₂O₃ (Alpha-Aluminium-Oxyd) aufgebracht, wobei vorteilhafterweise wiederum das PVD (Physical-Vapour-Deposition)-Verfahren verwendet wird. Diese zweite Schicht weist eine Dicke von etwa 2 µm auf, sie verfügt über eine glatte Oberfläche, wodurch das Abfliessen des Spans optimal ist.

Als zweite Schicht kann auf die angeschliffene Fase auch eine Diamantschicht aufgebracht werden. Hierbei ist es vorteilhaft, wenn die Fase vor der Beschichtung aufgerauht wird, wodurch wiederum eine mechanische Verankerung der Diamantschicht auf der aufgerauhten Fase erreicht wird. Diese Diamantschicht wird wiederum in vorteilhafter Weise durch Aufdampfen gemäss dem CVD (Chemical-Vapour-Deposition)-Verfahren auf die Fase aufgebracht. Mit dieser Diamantschicht erhält man eine sehr abrasionsbeständige Fase. Weil die Diamantschicht auf der ersten Schicht, mit welcher die Span- und die Freifläche versehen sind, schlecht haftet, verbleibt diese nur auf der Fasenfläche und dadurch kann durch die relativ dicke Diamantschicht eine übermässige Schneidkantenverrundung vermieden werden, was für den Zerspanungsvorgang sehr vorteilhaft ist.

Es ist auch denkbar, anstelle des Aufrauhens der Fase eine glatte Zwischenschicht als Haftgrundlage aufzubringen, auf welche danach eine (feine) Diamantschicht aufgebracht ist.

Die auf Bereichen der ersten Schicht typischerweise schlecht haftende zweite Schicht kann durch einen Nassstrahlvorgang in Bereichen, wo dies nicht erwünscht ist, entfernt werden.

Nachfolgend werden Ausführungsbeispiele beschrieben, die mit dem erfindungsgemässen Verfahren behandelt und bearbeitet wurden.

### Erstes Beispiel

Ein gemäss dem erfindungsgemässen Verfahren zu behandelndes und zu bearbeitendes Werkzeug besteht aus einem Hartmetall und weist beispielsweise vier Schneidflanken und vier Spannuten auf, wobei jede Schneidflanke auf der Schneidseite mit einer Schneidkante ausgestattet ist. Dieses Werkzeug wird mit dem PVD (Physical Vapour Deposition)-Verfahren beschichtet, wobei CrAlN (Chrom-Aluminium-Nitrid) verwendet wird. Geeignet wären auch TiAlN (Titan-Aluminium-Nitrid) oder TiAlCN (Titan-Aluminium-Carbo-Nitrid). Die Schichtdicke beträgt 2 µm. Danach wird an jeder Schneidkante eine Fase angeschliffen mit einer Oberflächenrauheit Rₐ = 0,05. Diese Fase weist einen Spanwinkel von etwa -20° auf, die Fasenbreite beträgt bei einem Werkzeugdurchmesser von 15 mm 0,6 mm. Denkbar wäre auch, dass die Fasen der vier Schneidkanten dieses Werkstücks unterschiedliche Fasenwinkel aufweisen würden. Danach wird auf jede Fase mit dem PVD-Verfahren eine Schicht aufgebracht, bestehend aus α-Al₂O₃ (Alpha-Aluminium-Oxyd). Diese Schicht wird hauptsächlich auf die Fase aufgebracht, da diese eine ebene Fläche aufweist und einfach beschichtet werden kann. Wenn diese Schicht auf den benachbarten Bereichen haften bleibt, ist dies nicht weiter tragisch, dieses Material wird dann während den Bearbeitungsvorgängen relativ schnell abgetragen oder kann abgestrahlt werden.

### Zweites Beispiel

Ein Fräswerkzeug aus Hartmetall, das wiederum beispielsweise vier Schneidflanken und vier Spannuten aufweist, wobei wiederum jede Schneidflanke auf der Schneidseite mit einer Schneidkante ausgestattet ist, wird über die gesamte Oberfläche aufgerauht, was durch das chemische Anätzen der Kobaltfase erfolgt, was aber immer auch eine Kantenverrundung zur Folge hat, die nicht erwünscht ist. Danach wird mit dem CVD (Chemical-Vapour-Deposition)-Verfahren eine Diamantschicht auf die gesamte Oberfläche aufgebracht, welche Diamantschicht eine Dicke von etwa 6 µm aufweist. Danach werden mit einem Flachschleifvorgang die Schneidkanten mit einer Fase versehen, wobei der Spanwinkel etwa -20° beträgt und wodurch die durch das Anätzen erhaltene Kantenverrundung wieder ausgeräumt wird. Auch hier können die Fasen jeweils unterschiedliche Spanwinkel aufweisen. Die Breite der Fase beträgt bei einem Werkzeug mit einem Durchmesser von 15 mm etwa 0,6 mm. Auf die angeschliffene Fase (Oberflächenrauheit Rₐ = 0,05) wird mit dem PVD-Verfahren eine Schicht aus α-Al₂O₃ aufgebracht, welche eine Dicke von etwa 2 µm aufweist und gegen Kolkverschleiss schützt. Dieses Material haftet schlecht auf der Diamantschicht, so dass ausschliesslich die blankgeschliffene Fase mit der entsprechenden Schicht versehen wird. Mit diesem Behandlungs- und Bearbeitungsverfahren wird ein Werkzeug erhalten, das eine sehr abrasionsfeste Freifläche aufweist, durch das Anschleifen der Fasen wird in diesem Bereich eine feine Oberfläche erhalten, wodurch in diesem Bereich eine Kerbwirkung bei Zugbeanspruchung verhindert wird, ein Ausbrechen der Kante wird vermieden.

### Drittes Beispiel

Das gemäss dem erfindungsgemässen Verfahren zu behandelnde und bearbeitende Werkzeug besteht wiederum aus einem Hartmetall, weist vier Schneidflanken und vier Spannuten auf, wobei die Schneidflanken auf der Schneidseite jeweils mit einer Schneidkante ausgestattet sind. Dieses Werkzeug wird mit einer Grundschicht aus CrAlN versehen, welche gemäss dem PVD-Verfahren aufgetragen wird und eine Dicke von etwa 2 µm aufweist. Auch hier wäre eine Schicht aus TiAlN oder TiAlCN geeignet. Danach wird an den Schneidkanten eine Fase angeschliffen, welche einen Spanwinkel von etwa -20° aufweist, wobei auch hier die Fasen der jeweiligen Schneidkanten unterschiedliche Spanwinkel aufweisen können. Die Fase weist bei einem Werkzeugdurchmesser von 15 mm eine Breite von etwa 0,6 mm auf, die Fasenflächen werden danach aufgerauht. Auf diese Fasenflächen wird mit dem CVD-Verfahren eine Diamantschicht aufgebracht, diese Diamantschicht haftet ausschliesslich auf dem aufgerauhten Bereich der Fasen. Diese Diamantschicht hat eine Dicke von typischerweise etwa 6 µm, bewirkt aber trotzdem keine Kantenverrundung. Die übrigen Bereiche des Werkzeugs haben eine feine Oberfläche. Auch dieses Werkzeug ist sehr abrasionsbeständig und verschleissfest.

Bei all diesen beschriebenen Beispielen können als Werkzeuge aus einem Hartmetall auch Werkzeuge aus Keramik, beispielsweise Si₃N₄-Keramik verwendet werden. Die Behandlungs- und Bearbeitungsvorgänge können auch bei diesen Keramikwerkzeugen in identischer Weise durchgeführt werden, wie bei den Werkzeugen aus Hartmetall, wobei ein Aufrauhen der zu beschichtenden Oberflächen nicht erforderlich ist.

Ebenfalls kann bei all diesen beschriebenen Beispielen die zweite Schicht, die auf Bereichen der Oberflächen haftet, wo sie nicht erwünscht ist, beispielsweise durch ein Nassstrahlverfahren beseitigt werden.

Mit diesem erfindungsgemässen Verfahren können Werkzeuge erhalten werden, die sich durch eine grosse Abrasionsbeständigkeit und zugleich Kolkverschleissbeständigkeit auszeichnen, selbst beim Bearbeiten von "schwierigen" Materialien und bei sehr hohen Abtragsleistungen.

## Patentansprüche

1. Verfahren zur Behandlung und Bearbeitung von Werkzeugen zur spanabhebenden Bearbeitung von Werkstücken, insbesondere Fräswerkzeuge, welche Werkzeuge aus einem hochfesten Stahl, Hartmetall oder Keramik bestehen und mit mindestens einer Schneidflanke und einer Spannut versehen sind, welche Schneidflanke auf der Schneidseite mit einer Schneidkante ausgestattet ist, bei welchem das Werkzeug in einer Beschichtungsanlage mit einer ersten Schicht versehen wird, welche widerstandsfähig ist gegen Freiflächenverschleiss, **dadurch gekennzeichnet, dass** danach an den Schneidkanten jeweils eine Fase angeschliffen wird, die einen Spanwinkel von -5° bis -30° aufweist und eine Fasenbreite aufweist, die kleiner ist als 5% des Durchmessers des Werkzeugs, und dass auf die angeschliffene Fase in einer Beschichtungsanlage eine zweite Schicht aufgebracht wird, die widerstandsfähig ist gegen Spanflächenverschleiss.

2. Verfahren nach Anspruch 1, **dadurch gekennzeichnet, dass** als erste Schicht eine Schicht aus CrAIN, TiAIN oder TiAICN aufgebracht wird.

3. Verfahren nach Anspruch 2, **dadurch gekennzeichnet, dass** die erste Schicht durch Aufdampfen gemäss dem PVD-Verfahren aufgebracht wird.

4. Verfahren nach Anspruch 1, **dadurch gekennzeichnet, dass** die mit der ersten Schicht zu beschichtende Oberfläche des Werkzeugs aufgerauht wird und dass als erste Schicht eine Diamantschicht aufgebracht wird.

5. Verfahren nach Anspruch 4, **dadurch gekennzeichnet, dass** die Diamantschicht durch Aufdampfen gemäss dem CVD-Verfahren aufgebracht wird.

6. Verfahren nach einem der Ansprüche 1 bis 5, **dadurch gekennzeichnet, dass** als zweite Schicht eine Schicht aus α-Al₂O₃ gemäss dem PVD-Verfahren aufgebracht wird.

7. Verfahren nach Anspruch 2 oder 3, **dadurch gekennzeichnet, dass** die Phase aufgerauht wird und als zweite Schicht eine Diamantschicht auf die Fase aufgebracht wird.

8. Verfahren nach Anspruch 7, **dadurch gekennzeichnet, dass** die Diamantschicht durch Aufdampfen gemäss dem CVD-Verfahren aufgebracht wird.

9. Verfahren nach einem der Ansprüche 1 bis 8, **dadurch gekennzeichnet, dass** die auf Bereichen der ersten Schicht haftende zweite Schicht, auf welchen Bereichen dies nicht erwünscht ist, durch einen Nassstrahlvorgang entfernt werden.

## Claims

1. Method for treatment and processing of tools for machining of workpieces in which material is removed from markpieces, in particular milling tools, which tools are made up of a high-strength steel, carbide or ceramic, and are provided with at least one cutting flank and a flute, which cutting flank is provided with a cutting edge on the cutting side, wherein in a coating installation the tool is provided with a first coating that is resistant to flank wear, **characterised in that** afterwards a bevel is ground on each of the cutting edges, which bevel has a rake angle of -5° to -30°, and a bevel width which is smaller than 5% of the diameter of the tool and **in that** in a coating installation a second coating is applied on the ground bevel, which coating is resistant to cutting face wear.

2. Method according to claim 1, **characterised in that** applied as a first coating is a coating of CrAIN, TiAIN or TiAICN.

3. Method according to claim 2, **characterised in that** the first coating is applied by vaporization according to the PVD method.

4. Method according to claim 1, **characterised in that** the surface of the tool to be coated with the first coating is roughened, and **in that** a diamond coating is applied as the first coating.

5. Method according to claim 4, **characterised in that** the diamond coating is applied by vaporization according to the CVD method.

6. Method according to one of the claims 1 to 5, **characterised in that** applied as the second coating is a coating of α-Al₂O₃ according to the PVD method.

7. Method according to claim 2 or 3, **characterised in that** the bevel is roughened, and a diamond coating is applied to the bevel as the second coating.

8. Method according to claim 7, **characterised in that** the diamond coating is applied by vaporization according to the CVD method.

9. Method according to one of the claims 1 to 8, **characterised in that** the second coating adhering to regions of the first coating is removed by a wet jet process on regions where it is not desired.

## Revendications

1. Procédé pour le maniement et le traitement d'outils pour l'usinage dans lequel on enlève du matériel de pièces à travailler, en particulier d'outils à fraiser, lesquels outils se composent d'un acier à haute résistance, de métal dur ou de céramique et sont pourvus d'au moins un flanc de coupe et d'une cannelure, lequel flanc de coupe comporte une arête sur le côté de coupure, dans lequel l'outil est pourvu d'une première couche dans une installation d'enduisage, la couche étant résistante à l'usure frontale, **caractérisé en ce qu'**ensuite un biseau est affûté sur chacune des arêtes de coupe, lequel biseau comporte un angle de coupe de -5° à - 30° et une largeur de biseau, qui est plus petite que 5% du diamètre de l'outil, et **en ce qu'**une deuxième couche est appliquée sur le biseau affûté dans une installation d'enduisage, la couche étant résistante à l'usure de la face de coupe.

2. Procédé selon la revendication 1, **caractérisé en ce qu'**une couche de CrAIN, TiAIN ou TiAICN est appliquée comme première couche.

3. Procédé selon la revendication 2, **caractérisé en ce que** la première couche est appliquée par vaporisation selon la méthode PVD.

4. Procédé selon la revendication 1, **caractérisé en ce que** la surface de l'outil qu'on va couvrir avec la première couche est rendue rugueuse et **en ce qu'**une couche de diamant est appliquée comme première couche.

5. Procédé selon la revendication 4, **caractérisé en ce que** la couche de diamant est appliquée par vaporisation selon la méthode CVD.

6. Procédé selon l'une quelconque des revendications 1 à 5, **caractérisé en ce qu'**une couche de α-Al₂O₃ est appliquée comme deuxième couche.

7. Procédé selon la revendication 2 ou 3, **caractérisé en ce que** le biseau est rendu rugueux, et une couche de diamant est appliquée au biseau comme deuxième couche.

8. Procédé selon la revendication 7, **caractérisé en ce que** la couche de diamant est appliquée par vaporisation selon la méthode CVD.

9. Procédé selon l'une quelconque des revendications 1 à 8, **caractérisé en ce que** la deuxième couche adhérant aux zones de la première couche sont éloignées par un processus de jet mouillé sur les zones où elle n'est pas désirée.
